# EUROPEAN PATENT APPLICATION

(11) **EP 4 672 327 A1**
(43) Date of publication of application: **31.12.2025**
(21) Application number: 25183355.4
(22) Date of filing: 17.06.2025
(51) Int. Cl.: H01L 23/433, H01L 23/373, H01L 25/07, H01L 23/31

(54) **HEAT DISSIPATION FOR SEMICONDUCTOR CIRCUIT**

(30) Priority: 28.06.2024 US 202463665387 P; 10.06.2025 US 202519233675
(71) Applicant: Avago Technologies International Sales Pte. Limited, Singapore 768923 (SG)
(72) Inventor: Zhang, Sheng, Cupertino, CA, 95014 (US); Margalit, Near, Westlake Village, CA, 91361 (US); Meadowcroft, David John Kenneth, Bury St Edmunds, Suffolk, IP30 9PG (GB); Kannan, Sukeshwar, San Jose, CA, 95124 (US)
(74) Representative: Grünecker Patent- und Rechtsanwälte PartG mbB

(57) **Abstract**

The subject technology is directed to semiconductors and fabrication methods thereof. The subject technology provides a first circuit, a die attach film coupled to a bottom side of the first circuit, and a heat spreader layer coupled between the first circuit and the die attach film. In some cases, the heat spreader layer is directly coupled to at least one of the first circuit or the die attach film. In some cases, the first layer or the die attach film is non-conductive. The heat spreader layer can be configured to dissipate heat laterally along a side of the first circuit. There are other embodiments as well.

## Description

### CROSS-REFERENCE TO RELATED APPLICATIONS

The present application claims priority to United States patent application number 63/665,387, filed on June 28, 2024, the disclosure of which is herein incorporated by reference in its entirety.

### FIELD OF INVENTION

The subject technology is directed to semiconductor devices.

### BACKGROUND OF THE INVENTION

Semiconductor packages are essential components that provide both physical support and electrical connectivity for integrated circuits. They protect the circuits from environmental factors and facilitate the routing of electrical signals between the circuits and external systems. As electronic devices continue to evolve, there is a growing demand for semiconductor packages that can accommodate high-power applications and higher levels of integration. These applications often necessitate complex circuitry and multiple interconnected components, placing greater demands on the thermal performance of these packages.

Various approaches for improving thermal performance of these packages have been explored, but they have proven to be insufficient. It is important to recognize the need for new and improved systems and methods.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 illustrates a cross-sectional view of a semiconductor device, in accordance with an embodiment of the present disclosure.
Figure 2 illustrates a cross-sectional view of another semiconductor device, in accordance with an embodiment of the present disclosure.
Figure 3 is a simplified block diagram illustrating a method to form a semiconductor device according to embodiments of the subject technology.

### DETAILED DESCRIPTION OF THE INVENTION

The subject technology is directed to semiconductor devices and fabrication methods thereof. The subject technology provides a first circuit, a die attach layer or die attach film coupled to a bottom side of the first circuit, and a heat spreader layer coupled between the first circuit and the die attach layer. In some cases, the heat spreader layer is directly coupled to at least one of the first circuit or the die attach layer. In some cases, the die attach film is non-conductive. The heat spreader layer can be configured to dissipate heat laterally along a side of the first circuit coupled to the heat spreader layer.

Semiconductor packages are increasingly requiring more functionality which places greater demand on the performance of the devices used in these packages. In one non-limiting example, in 3D fan-out-wafer-level packaging, two circuits or two dies are typically packaged together vertically, with the bottom circuit at least partially embedded in a mold compound. The electrical connections between the two circuits are achieved through one or more redistribution layers ("RDLs"). A heatsink can be attached to the top circuit of the package. The heat generated by the bottom circuit is removed through the one or more RDLs, the top circuit, and the heatsink. Due to the high thermal resistance of the RDLs, there is a high-temperature gradient between the two circuits. For example, the bottom circuit typically has a higher temperature relative to the top circuit. Additionally, the power distribution over the bottom circuit is not uniform. With the high thermal resistance of the RDLs and the non-uniform power distribution, hot spot areas are often formed at the active areas (e.g., areas including active devices, or the like) of the bottom circuit. The integrated circuit components, such as transistors, resistors, capacitors, etc., at these hot spot areas will degrade in performance or, in extreme cases, fail.

In various embodiments, the subject technology provides semiconductor devices that include a heat spreader layer. The heat spreader layer can be coupled between a die attach layer and a first circuit. The die attach layer can be non-conductive. In some cases, the heat spreader layer is coupled to a bottom side of the first circuit. The heat spreader layer can be a lateral heat spreader layer configured to dissipate heat laterally along the bottom side of the first circuit coupled to the heat spreader layer.

By dissipating heat laterally along the side of the first circuit, the effect of heat spots can be at least partially or fully reduced. For example, the heat spreader layer improves heat conduction between different areas of the first circuit and reduces the thermal resistance between the hot spots and the other lower power density areas of the first circuit. Effectively, the heat generated from the high power density areas of the first circuit will be distributed laterally along the side of the first circuit and pulled through a larger RDL area. Thus, reducing the temperature at the hot spot areas.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, a dielectric layer may comprise multiple dielectric materials or multiple layers of dielectric materials, a device layer can include one or more resistors, capacitors, inductors, diodes, transistors, integrated circuits, etc. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Additionally, when an element is referred to herein as being a "circuit," a circuit is commonly recognized as a building block of modern electronics. Circuits are composed of various electronic components such as resistors, capacitors, inductors, diodes, transistors, integrated circuits, etc. Integrated circuits can be formed from one or more circuits. In some cases, circuits can also include optical components or other components. These electronic components, optical components, or other components are carefully selected and interconnected to create a circuit that can perform a specific task or carry out a particular function. Circuits can be categorized into different types based on their purpose or function, including amplifiers, oscillators, filters, power supplies, logic gates, electronic circuits, photonic circuits, among others.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components. Additionally, use of the terms first, second, third, etc. are used for purposes of explanation only and to distinguish elements from one another. They are not intended to recite a certain order unless expressly stated in this disclosure.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." Unless otherwise specified or limited, the terms 'about' and 'approximately,' as used herein with respect to a reference value, refer to variations from the reference value of ± 20% or less (e.g., ± 20%, ± 15%, ± 10%, ± 5%, etc.), inclusive of the endpoints of the range.

In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

In a first aspect, a semiconductor device can include a first circuit, a die attach film coupled to a bottom side of the first circuit, and a heat spreader layer coupled between the first circuit and the die attach film.

In some examples, the die attach film is non-conductive and can include at least one of an adhesive, an epoxy, a thermoplastic, or a thermosetting polymer resin.

In some instances, a first ratio of a first thickness of the first circuit to a second thickness of the heat spreader layer is about 5:1 to about 1:2 and a second ratio of the second thickness of the heat spreader layer to a third thickness of the die attach film is about 1:1 to about 10:1.

In various cases, the heat spreader layer includes graphene.

In various examples, at least a first portion of the heat spreader layer is directly coupled the die attach film and at least a second portion of the heat spreader layer is directly coupled the first circuit. The first circuit, the die attach film, and the heat spreader layer can be fully encapsulated in a mold compound.

In some cases, the heat spreader layer is thicker than the die attach film.

In various instances, the first circuit, the die attach film, and the heat spreader layer are fully encapsulated in a mold compound.

In some examples, the semiconductor device further includes a second circuit coupled to a top side of the first circuit and a surface of the mold compound and the second circuit is a photonic integrated circuit. The semiconductor device can also include a heatsink coupled to the second circuit, wherein the second circuit is between the first circuit and the heatsink.

In another aspect, an apparatus can include a first circuit, a die attach film coupled to a bottom side of the first circuit, and a heat spreader layer coupled between the first circuit and the die attach film. The heat spreader layer can be directly coupled to the die attach layer and a bottom side of the first circuit.

In some instances, the heat spreader layer includes graphene and the graphene is directly coupled to the die attach layer and the bottom side of the first circuit using an adhesive.

In various cases, the die attach layer is non-conductive.

In some examples, a thermal conductivity of the heat spreader layer to the thermal conductivity of the die attach layer is between about 1600:1 to about 160:1.

In yet another aspect, an apparatus can include a first circuit, a die attach film coupled to a bottom side of the first circuit, and a heat spreader layer coupled between the first circuit and the die attach film. The first circuit, the die attach layer, and the heat spreader layer can be embedded within a mold compound. The apparatus can further include a second circuit coupled to a top side of the first circuit and a redistribution layer coupled between the first circuit and the second circuit.

In some cases, the apparatus can include a heatsink and the second circuit is between the heatsink and the redistribution layer.

In various instances, the first circuit is an electronic integrated circuit and the second circuit is a photonic integrated circuit.

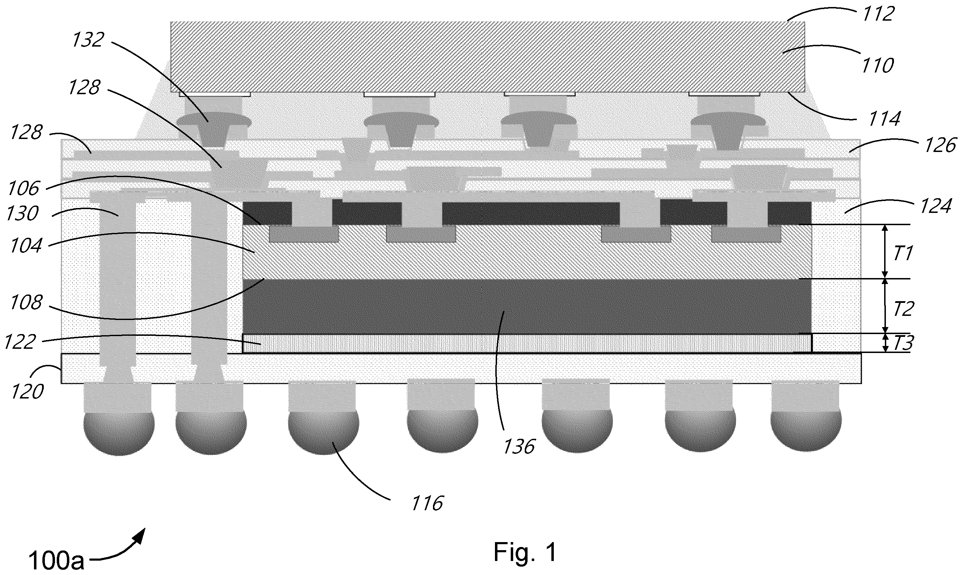

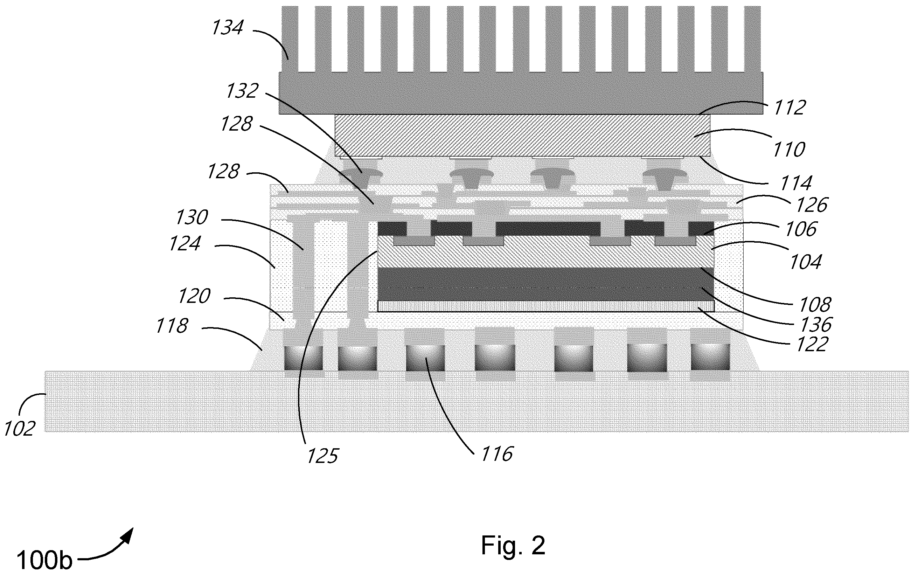

FIGS. 1 and 2 illustrate a semiconductor device 100a and a semiconductor device 100b according to various embodiments. Semiconductor device 110b is similar to semiconductor device 100a except that semiconductor device 110b includes a few extra semiconductor components such as substrate 102 and heatsink 134. It should be noted that persons of ordinary skill in the art would understand that the semiconductor device 100 could have more or less components than the components shown and the semiconductor device 100 should not be limited to only the examples shown. It should be further noted that the figures of this disclosure merely provide examples, which should not unduly limit the scope of the claims. One of ordinary skill in the art would recognize many variations, alternatives, and modifications.

In various cases, semiconductor device 100 can be a 3D fan-out wafer-level package or other semiconductor device. The semiconductor device 100 can include an optional substrate or circuit board 102, shown in FIG. 2. The substrate 102 can include a supporting material (e.g., silicon, glass, and/or any other material or combination of materials) upon which or within which elements or components (e.g., connectors, passive devices, active devices, dies, circuits, or the like) of a semiconductor device 100 are fabricated or coupled. In some cases, the substrate 102 is configured to provide power or electrical connections to other components of semiconductor device 100. In some cases, the substrate 102 can be a printed circuit board. In various cases, the substrate 102 is formed of one or more layers. The one or more layers can include, without limitation, one or more dielectric layers, one or more device layers, one or more conducting layers, one or more insulating layers, one or more redistribution layers, other layers, and/or the like.

The semiconductor device 100 can include a first circuit, first die, or bottom circuit 104 having a top side 106 and a bottom side 108 coupled to the substrate 102 and a second circuit, second die, or top circuit 110 having a top side 112 and a bottom side 114 coupled to the first circuit 104. In other words, the first circuit 104 is between the substrate 102 and the second circuit 110 or the top circuit 110 is stacked on top of the bottom circuit 104. The first circuit 104 and the second circuit 110 can include one or more layers. The one or more layers can include, without limitation, one or more dielectric layers, one or more device or circuit layers, one or more conducting layers, one or more insulating layers, one or more redistribution layers, other layers, and/or the like. The layers may further include one or more layers configured to provide component interconnections.

In various instances, the top side 106 of the first circuit 104 and the top side 112 of the second circuit 110 are device sides. In other words, the top sides 106 and 112 are where most of the devices including one or more transistors, diodes, amplifiers, transmitters, resistors, capacitors, or the like are located. In some cases, the top sides 106 and 112 are where most of the active devices are located such as one or more transistors, diodes, amplifiers, transmitters, or the like. However, it should be noted that the devices including one or more transistors, diodes, amplifiers, transmitters, resistors, capacitors, or the like could also be located in other locations on or in the first circuit 104 or second circuit 110. The bottom side 108 of the first circuit 104 and the bottom side 114 of the second circuit 110 are opposite the top sides 106 and 112, respectively.

The bottom side 108 of the first circuit 104 couples to the substrate 102 while the top side 106 of the first circuit 104 couples to the second circuit 110. In various cases, the bottom side 114 of the second circuit 110 couples to the first circuit 104.

In some examples, the bottom side 108 of the first circuit 104 couples to the substrate 102 using one or more connections 116. The one or more connections 116 can include one or more solder bumps, micro bumps, pads, vias, traces, or the like. In some cases, the one or more connections 116 can be embedded in an underfill material 118. The underfill material 118 can include, without limitation, an adhesive, an epoxy, encapsulation mold compound, or the like. In some cases, an optional adhesive layer or dielectric layer 120 can further be used to couple the first circuit 104 to the substrate 102. The adhesive layer 120 can include polyamide, build up layer, or the like.

Additionally, in some cases, a die attach film, a die attach layer, or a first layer 122 can be used to attach the first circuit 104 to the adhesive layer 120 or alternatively the substrate 102. The die attach film 122 includes an adhesive material used to bond the first circuit 104 to the substrate 102. The die attach film 122 can be flexible. In some cases, the die attach film 122 can be non-conductive. Non-conductive as used herein means a thermal conductivity of about 0.5 watts per meter kelvin (W/m·K) or less. When the die attach film 122 is non-conductive, the die attach film 122 can include a thermoplastic, a polymer resin, an epoxy, a polyimide, a bismaleimide, silicone, or the like, and non-conductive fillers like silica, alumina, aluminum hydroxide, mica, glass, and organic fillers, or the like. In some cases, the die attach film 122 can be conductive. A conductive die attach film typically has a thermal conductivity of about 2.5 W/m·K to about 8 W/m·K or more. When the die attach film 122 is conductive, the die attach film 122 can include a thermoplastic, a polymer resin, an epoxy, a polyimide, a bismaleimide, silicone and a conductive fillers like nickel, silver, gold or the like.

In some cases, the first circuit 104 is at least partially embedded, substantially embedded, or fully embedded in a mold compound 124. "Substantially embedded" as used herein means about 80 percent or more of the sides 125 of the first circuit 104 are embedded in the mold compound 124. The mold compound 124 can include, without limitation, an epoxy or an epoxy with filler particles, or the like. In some cases, the top circuit 110 can be coupled to a top surface of the mold compound 124.

The first circuit 104 and the second circuit 110 can be integrated circuits or electronic integrated circuits ("EICs") configured to perform one or more functions. The first circuit 104 or the second circuit 110 can incorporate various electronic components or devices, such as transistors, diodes, resistors, and capacitors, onto or within a single substrate to perform the one or more functions. The one or more functions can include, without limitation, one or more memory functions, one or more switching functions, one or more processor functions, or the like.

In some cases, the first circuit 104 and the second circuit 110 can be a photonic integrated circuit ("PIC"). The PIC can be a circuit or an integrated circuit that controls and manipulates light signals. PICs can incorporate a combination of active and passive optical components, including lasers, modulators, detectors, waveguides, splitters, couplers, filters, and other optical elements. In some cases, the PIC can be optically coupled to one or more optical signal sources such as optical fibers, photo diodes, lasers, or the like. The PIC can have one or more circuits configured to receive, transmit, or convert one or more optical signals. The PIC can be configured to receive one or more optical signals from the one or more optical signal sources, transmit the one or more optical signals inside the PIC, transmit the one or more optical signals out of the PIC, and/or the like. In some cases, PIC can be configured to convert the one or more optical signals received from the one or more optical signal sources to one or more electrical signals and communicate the one or more electrical signals to an EIC. In some cases, the PIC is configured to receive one or more electrical signals from the EIC (e.g., to control the one or more optical sources, or the like).

In some cases, the first circuit 104 is an EIC and the second circuit 110 is a PIC. Alternatively, in other cases, the first circuit 104 and the second circuit 110 are EICs. Alternatively, in other cases, the first circuit 104 and the second circuit 110 are PICs. Alternatively, in some cases, the first circuit 104 is a PIC and the second circuit 110 is EIC.

In some examples, the bottom side 114 of the second circuit 110 couples to the first circuit 104 using one or more redistribution layers (RDLs) 126 between the first circuit 104 and the second circuit 110 and one or more second connections 128. The one or more RDLs 126 can include one or more dielectric layers, one or more conducting layers, one or more insulating layers, other layers, and/or the like. In various cases, the one or more RDLs 126 are configured to route the one or more second connections 128 to desired locations (e.g., from the first circuit 104 to the second circuit 110, from the substrate 102 to the first circuit 104 or the second circuit 110, or the like). In some cases, the one or more RDLs 126 can be configured to deliver electrical signals via the one or more second connections 128. In various cases, the one or more second connections 128 include one or more vias, one or more pads, one or more traces, one or more conductive planes, or the like.

In some cases, the mold compound 124 might include one or more third connections 130. The one or more third connections 130 can include one or more solder bumps, micro bumps, pads, vias, traces, or the like. In some cases, the one or more third connections 130 can be embedded in the mold compound 124.

In some cases, the second circuit 110 can be connected to the RDLs using one or more fourth connections 132. The one or more fourth connections 132 could include one or more vias, one or more pads, one or more traces, one or more solder bumps, one or more micro bumps, one or more conductive planes, or the like.

In various instances, the semiconductor device 100 can further include a heatsink 134 coupled to the second circuit 110 shown in FIG. 2. The heatsink 134 can be coupled to the top side 112 of the second circuit 110. The heatsink 134 can be configured to dissipate heat and prevent overheating of the semiconductor device 100. Heatsink 134 can be formed of a thermally conductive material, including one or more of aluminum, copper, steel, or other material capable of conducting heat.

As discussed above, it is difficult to conduct heat away from the first circuit 104 because of the high thermal resistance of the RDLs 126 and the fact that the first circuit 104 is embedded or at least partially embedded in the mold compound 124. Thus, one or more heat spots can be formed within or on the first circuit 104. In order to more effectively dissipate heat from the first circuit 104, a heat spreader layer 136 can be coupled between the bottom side 108 of the first circuit and the die attach film 122. In various cases, the heat spreader layer 136 is configured to spread the heat laterally along the bottom side 108 of the first circuit 104 to more efficiently dissipate the heat from the first circuit 104 through the RDLs 126 to the heatsink 134. In various cases, the heat spreader layer 136 can include graphene, one or more layers of graphite, diamond, silver, copper, gold, aluminum nitride, silicon carbide, and cubic boron arsenide or other heat dissipating material with a higher thermal conductivity than silicon.

In some cases, the heat spreader layer 136 directly contacts or couples to at least one of the bottom side 108 of the first circuit 104 and directly contacts or couples to a top surface of the die attach film 122. In some cases, the heat spreader layer 136 directly contacts or couples to at least one of the bottom side 108 of the first circuit 104 and directly contacts or couples to a top surface of the die attach film 122 using an adhesive. By placing the heat spreader layer 136 between the bottom side 108 of the first circuit 104 and the die attach film 122 or in direct coupling with the bottom side 108 of the first circuit 104 and the die attach film 122, heat is more evenly spread laterally along the bottom side 108 of the first circuit 104. Spreading the heat laterally along the bottom side 108 of the first circuit 104 is more difficult when the first circuit is directly connected to the die attach film 122 because the die attach film 122 is often non-conductive which traps heat where one or more active devices are located in the first circuit 104 forming one or more hot spots. Even when the die attach film 122 is conductive, the thermal conductivity of the die attach film 122 is often much lower than the thermal conductivity of the heat spreader layer 136. Thus, hot spots are still likely to occur on the bottom side 108 of the first circuit 104 even when the die attach film 122 is conductive.

In various cases, the first circuit 104, the die attach film 122, and the heat spreader layer 136 are at least partially, substantially, or fully embedded or encapsulated in the mold compound 124. When the first circuit 104 and the die attach film 122 are at least partially, substantially, or fully encapsulated in the mold compound 124, heat is more easily trapped in the first circuit 104 forming one or more hot spots. Thus, placing the heat spreader layer 136 between the first circuit 104 and the die attach film 122 and embedded in the mold compound 124 helps spread the heat laterally along the bottom side 108 of the first circuit 104 and to dissipate the heat from the first circuit 104.

In some cases, a top surface of the heat spreader layer 136 can be about a same size or a same area as a bottom surface of the first circuit 104. By having the heat spreader layer 136 be about the same size, the heat spreader layer 136 can be more easily diced with the first circuit from a wafer. In some instances, the heat spreader layer 136 can be larger or be between about 0.5 percent to about 30 percent larger than a bottom surface of the first circuit 104 to more effectively dissipate the heat along the bottom side of the first circuit 104.

In various cases, a first thickness T1 of the first circuit can be about 30 micrometers to about 160 micrometers. A second thickness T2 of the heat spreader layer 136 can be about 80 micrometers to about 120 micrometers. A third thickness T3 of the die attach film 122 can be about 5 micrometers to about 25 micrometers. In some cases, the second thickness T2 of the heat spreader layer 136 can be greater than the third thickness T3 of the die attach film 122. Thus, improving heat dissipation along the bottom side of the first circuit 104.

A first ratio of a first thickness T1 of the first circuit 104 to a second thickness T2 of the heat spreader layer 136 is about 5:1 to about 1:2. The proposed first ratio helps dissipate the heat along the bottom side 108 of the first circuit 104. A second ratio of the second thickness T2 of the heat spreader layer 136 to a third thickness T3 of the die attach film 122 is about 1:1 to about 10:1. By providing a thicker heat spreader layer 136 between the die attach film 122 and the first circuit 104, heat can be more effectively laterally spread along the bottom side 108 of the first circuit 104.

In some cases, a thermal conductivity of the die attach film 122 is about 8 watts per meter kelvin or less and a thermal conductivity of the heat spreader layer is between about 1300 watts per meter kelvin and 1600 watts per meter kelvin. Thus, a third ratio of a thermal conductivity of the heat spreader layer 136 to the thermal conductivity of the die attach film 122 is between about 1600:1 to about 160:1. By providing a heat spreader layer 136 having greater thermal conductivity than the die attach film 122, heat can be more effectively laterally spread along the bottom side 108 of the first circuit 104.

Thus, the heat spreader layer 136 improves heat conduction between different areas of the first circuit 104, reducing the thermal resistance between the hot spots and the other lower power density areas of the first circuit 104. Effectively, the heat generated from the high power density areas will be distributed among larger areas of the first circuit 104 and pulled through a larger RDL area. This will reduce the junction temperature at the hot spot area of the first circuit 104.

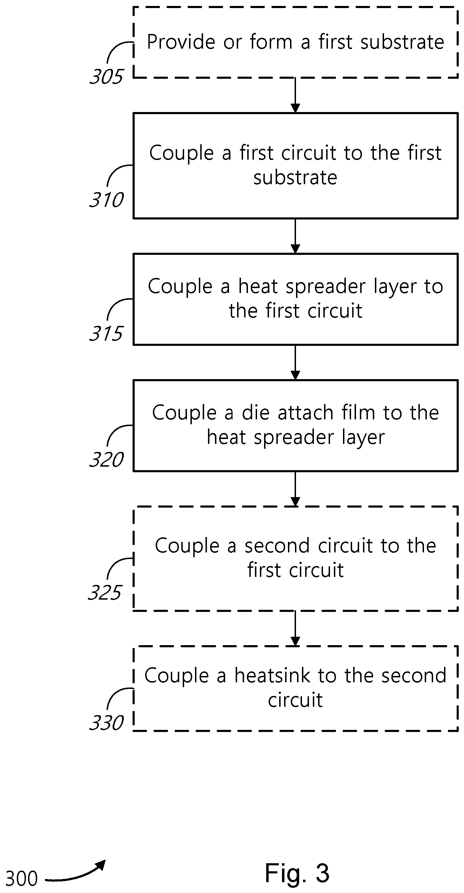

FIG. 3 is a block diagram illustrating method 300 for fabricating a semiconductor device 100 according to embodiments of the subject technology. This diagram merely provides an example, which should not unduly limit the scope of the claims. One of ordinary skill in the art would recognize many variations, alternatives, and modifications. In some cases, the method 300 can also be performed in a different order than the order described.

In various implementations, method 300 may be used to fabricate semiconductor device 100 or portions of semiconductor device 100 illustrated in FIGS. 1 and 2, which can be applied across a wide range of applications, including high-power electronics, large-scale packages, high-density integrated circuits, and/or the like. In some embodiments, method 300 may include at optional block 305 (e.g., manual operation or machine operation) providing a substrate (e.g., substrate 102 or the like). The method 300 may also include, at block 310, coupling or disposing a first circuit (e.g., first circuit 104, or the like) to a first side of the substrate. This step can be performed by adhering or coupling the first circuit on or to the first side of the substrate.

In some cases, the first circuit is formed separately from the substrate. In other cases, the first circuit is formed on the substrate. In some cases, the first circuit is formed by forming one or more layers of the first circuit. Next, method 300, at block 315 can include coupling a heat spreader layer (e.g., heat spreader layer 136, or the like) to the bottom side of the first circuit and, at block 320, coupling a die attach film (e.g., die attach film 122, or the like) to the heat spreader layer. In some cases, the heat spreader layer 136 can be coupled or adhered to the first circuit using an adhesive including, but not limited to, an epoxy, aa silicone adhesive, an acrylic adhesive, another adhesive or the like. In some cases, two or more first circuits can be formed on a wafer with the heat spreader layer attached. The first circuit and the heat spreader layer can then be diced together and coupled to the substrate using the die attach film.

Next, at block 325, the method 300 can include optionally coupling or disposing a second circuit (e.g., second circuit 110, or the like) to the first circuit. In some cases, the second circuit can be stacked on top of the first circuit. In some cases, the second circuit is formed separately from the first circuit and the substrate. In other cases, the second circuit is formed on the first circuit or the substrate. In some cases, the second circuit is formed by forming one or more layers of the second circuit. The method can further include optionally coupling a heatsink (e.g., heatsink 134, or the like) to the second circuit at block 330.

While the above is a full description of the specific embodiments, various modifications, alternative constructions and equivalents may be used. Therefore, the above description and illustrations should not be taken as limiting the scope of the subject technology which is defined by the appended claims.

## Claims

1. A semiconductor device comprising:
a first circuit;
a die attach film coupled to a bottom side of the first circuit; and
a heat spreader layer coupled between the first circuit and the die attach film.

2. The semiconductor device of claim 1, wherein the die attach film is non-conductive,
in particular,
wherein the die attach film includes at least one of an adhesive, an epoxy, a thermoplastic, or a thermosetting polymer resin.

3. The semiconductor device of claim 2, wherein a first ratio of a first thickness of the first circuit to a second thickness of the heat spreader layer is about 5:1 to about 1:2,
in particular,
wherein a second ratio of the second thickness of the heat spreader layer to a third thickness of the die attach film is about 1:1 to about 10:1.

4. The semiconductor device of claim 2, wherein the heat spreader layer includes graphene.

5. The semiconductor device of one of the previous claims, wherein at least a first portion of the heat spreader layer is directly coupled the die attach film,
in particular,
wherein at least a second portion of the heat spreader layer is directly coupled the first circuit.

6. The semiconductor device of claim 5, wherein the first circuit, the die attach film, and the heat spreader layer are fully encapsulated in a mold compound.

7. The semiconductor device of one of the previous claims, wherein the heat spreader layer is thicker than the die attach film.

8. The semiconductor device of one of the previous claims, wherein the first circuit, the die attach film, and the heat spreader layer are fully encapsulated in a mold compound.

9. The semiconductor device of claim 8, further comprising a second circuit coupled to a top side of the first circuit and a surface of the mold compound, and wherein the second circuit is a photonic integrated circuit,
in particular,
the semiconductor device further comprising a heatsink coupled to the second circuit, wherein the second circuit is between the first circuit and the heatsink.

10. An apparatus comprising:
a first circuit;
a die attach layer coupled to the first circuit; and
a heat spreader layer coupled between the first circuit and the die attach layer,
wherein the heat spreader layer is directly coupled to the die attach layer and a bottom side of the first circuit.

11. The apparatus of claim 10, wherein the heat spreader layer includes graphene, and wherein the graphene is directly coupled to the die attach layer and the bottom side of the first circuit using an adhesive.

12. The apparatus of claims 10 or 11, wherein the die attach layer is non-conductive.

13. The apparatus of one of claims 10 to 12, wherein a ratio of a thermal conductivity of the heat spreader layer to the thermal conductivity of the die attach layer is between about 1600:1 to about 160:1.

14. An apparatus comprising:
a first circuit;
a die attach layer coupled to a bottom side of the first circuit;
a heat spreader layer coupled between the first circuit and the die attach layer, wherein the first circuit, the die attach layer, and the heat spreader layer are embedded within a mold compound;
a second circuit coupled to a top side of the first circuit; and
a redistribution layer coupled between the first circuit and the second circuit.

15. The apparatus of claim 14 further comprising a heatsink, wherein the second circuit is between the heatsink and the redistribution layer,
and/or
wherein the first circuit is an electronic integrated circuit and the second circuit is a photonic integrated circuit.
